Europäisches Patentamt

European Patent Office

Office européen des brevets

(19)

(11) Publication number: **0 187 260 B1**

(12) # EUROPEAN PATENT SPECIFICATION

(45) Date of publication of patent specification: **31.07.91**

(51) Int. Cl.⁵: **H01L 21/82, H01L 29/78, H01L 27/08, H01L 29/10, H01L 29/08**

(21) Application number: **85115271.0**

(22) Date of filing: **02.12.85**

The file contains technical information submitted after the application was filed and not included in this specification

(54) **Process for fabricating a semiconductor integrated circuit device having MISFETs.**

(30) Priority: **03.12.84 JP 254010/84**

(43) Date of publication of application:
**16.07.86 Bulletin 86/29**

(45) Publication of the grant of the patent:
**31.07.91 Bulletin 91/31**

(84) Designated Contracting States:
**DE FR GB IT**

(56) References cited:
**EP-A- 0 113 540**

**IEEE TRANSACTIONS ON ELECTRON DE-VICES, vol. ED-28, no. 7, July 1981, pages 888-890, IEEE, New York, US; K. YAMAGUCHI et al.: "Submicron gate MOSFET's with channel-doped separate gate structures (SG-MOSFET's)"**

(73) Proprietor: **HITACHI, LTD.**
**6, Kanda Surugadai 4-chome**
**Chiyoda-ku, Tokyo 100(JP)**

(72) Inventor: **Ikeda, Shuji**
**15-3, Midori-cho 5-chome**
**Koganei-shi Tokyo(JP)**
Inventor: **Koike, Atsuyoshi**
**21-11, Higashikoigakubo 2-chome**
**Kokubunji-shi Tokyo(JP)**
Inventor: **Meguro, Satoshi**
**2196-662, Hirai Hinode-machi**
**Nishitama-gun Tokyo(JP)**
Inventor: **Okuyama, Kousuke**
**Hitachi Nishiki-sou 205 2-5, Nishiki-cho 6-chome**
**Tachikawa-shi Tokyo(JP)**

(74) Representative: **Strehl, Schübel-Hopf, Groening**
**Maximilianstrasse 54 Postfach 22 14 55**
**W-8000 München 22(DE)**

IEEE INTERNATIONAL ELECTRON DEVICES MEETING 1983, TECHNICAL DIGEST, Washington, D.C., US, 5th-7th December 1983, pages 340-343, IEEE, New York, US; R. MAUNTEL et al.: "A 1.5 micron HCMOS III technology for fast static RAMS"

IEEE TRANSACTION ON ELECTRON DEVICES, vol. ED-31, no. 2, February 1984, pages 205-214, IEEE, New York, US; T. YAMAGUCHI et al.: "Process and device performance of 1 mum-channel n-well CMOS technology"

IEEE INTERNATIONAL ELECTRON DEVICES MEETING 1978, TECHNICAL DIGEST, Washington, D.C., US, 4th-6th December 1978, pages 26-29; K. NISHIUCHI et al.: "A normally-off type buried channel MOSFET for VLSI circuits"

## Description

### BACKGROUND OF THE INVENTION

The present invention relates to a semiconductor integrated circuit device and, more particularly, to a semiconductor integrated circuit device which includes a MISFET intended to prevent the short channel effect and to raise the breakdown voltage, and a process for fabricating the same.

In accordance with the high-density of semicounductor integrated circuit devices (i.e. IC) in recent years, the fineness (scaling-down) of elements is being advanced. In a MISFET (i.e., Metal Insulator Semiconductor Field Effect Transistor), too, gate length (or channel length) has been shortened, and junctions have been shallowed. However, this scaling-down is accompanied by problems such as the short channel effect or reduced threshold voltage of the MOSFET, increased resistance of the source and drain regions, generation of hot carriers, reduced breakdown voltage of the drain junction.

In view of this background, there has been proposed a MOSFET which has an LDD (Lightly Doped Drain) structure so as to solve the above problems, as is disclosed in IEEE Transactions on Electron Devices, vol. ED-29, No. 4, 1982, pp. 590 to 596, for example. In this LDD structure, more specifically, the source and drain regions comprise a semiconductor region of high impurity concentration, which is formed apart from a gate electrode, and a semiconductor region of low impurity concentration which is integral with the former semiconductor region and extends to the end portion of the gate electrode.

In IEEE Transactions on Electron Devices, vol. ED-28, No. 7, 1981, pages 888 to 890, a MISFET is described in which a semiconductor region is provided below the gate electrode, which region has the same conductivity type as the source and drain regions and is integral therewith, to achieve improvements with respect to the drain breakdown voltage and punch-through phenomenon. Similar MISFET structures are disclosed in EP-A-0 113 540 which further illustrates an integrated circuit including MISFETs of opposite conductivity types and a method of manufacturing such a circuit in accordance with the features set forth in the first part of claim 1.

### SUMMARY OF THE INVENTION

It is an object of the present invention to provide a method for manufacturing a semiconductor integrated circuit including MISFETs of opposite conductivity types, in which one of these MISFETs has a channel layer of the same conductivity type as, and integral with, its source and drain regions and which is further improved with respect to breakdown voltage and short-channel effect.

The invention meets this object by the method characterized in claim 1.

### BRIEF DESCRIPTION OF THE DRAWINGS

Fig. 1 is a sectional view showing an embodiment in which the present invention is applied to a complementary MOS type semiconductor integrated circuit device;

Figs. 2A to 2G are sectional views showing the steps of fabricating the semiconductor integrated circuit device of Fig. 1; and

Fig. 3 is a sectional view showing an example in which the present invention is applied to an N-channel MOSFET.

### DESCRIPTION OF THE PREFERRED EMBODIMENT

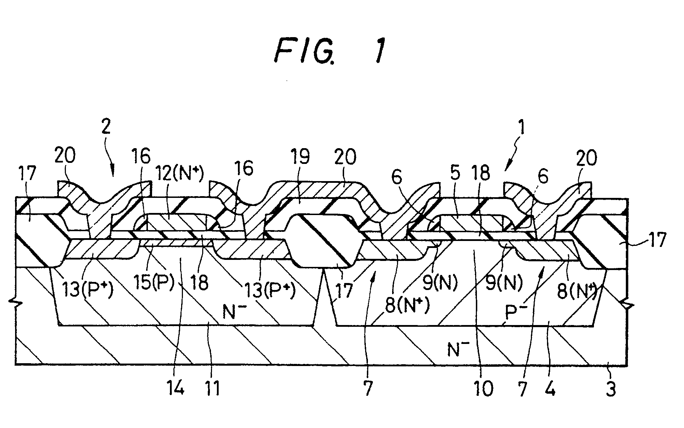

Fig. 1 shows an example in which the present invention is applied to the CMOSIC. Especially in the CMOSIC constructed of an N-channel MOSFET 1 and a P-channel MOSFET 2, the LDD structure is applied to the N-channel MOSFET 1 whereas the present invention is applied to the P-channel MOSFET 2.

The N-channel MOSFET 1 is formed in the P-type well (or semiconductor region) 4 in a semiconductor substrate 3 made of $N^-$-type single crystalline silicon. The MOSFET 1 comprises a gate electrode 5 made of a polycrystalline silicon film, a gate insulating film 18 made of a silicon oxide film and source and drain regions 7 which have the LDD structure formed by making use of side wall spacers 6 at both the sides of the gate electrode 5. The source and drain regions 7 of the LDD structure comprise $N^+$-type semiconductor regions 8 of high impurity concentration formed apart from the gate electrode, and N-type semiconductor regions 9 of low impurity concentration which is integral with the $N^+$-type semiconductor regions 8 and extend below the gate electrode 5. In the case of the present embodiment, the $N^+$-type semiconductor regions 8 are made of arsenic (As), whereas the N-type semiconductor regions 9 are made of phosphorus (P). Boron (B) for adjusting the threshold voltage is introduced (although not shown) below the gate electrode 5, i.e., into the surface of a channel 10 by the ion implantation.

The P-channel MOSFET 2 is formed in an $N^-$-type well (or semiconductor region) 11 in the substrate 3. The MOSFET 2 comprises a gate electrode 12 made of polycrystalline silicon highly doped with an N-type impurity, the gate insulating film 18 and $P^+$-type source and drain regions 13. These source and drain regions 13 are formed apart from the aforementioned gate electrode 12. In other words, the ends of the regions 13 are absent below the gate electrode 12. The respective source and drain regions 13 are constructed to be connected with a channel layer 15 of P-type semiconductor region, which is formed below the gate electrode 12, i.e., on the surface of a channel 14. That channel layer 15 is formed to have a relatively low concentration by introducing boron simultaneously with the ion implantation for adjusting the threshold voltage of the aforementioned N-channel MOSFET 1. At the same time, the source and drain regions 13 are doped in high concentration with the boron or the identical impurity. The region 15 is made to have a lower impurity concentration and a shallower junction than those of the regions 13. Indicated at reference numerals 16 are side wall spacers which are formed at both the sides of the gate electrode 12.

In the Drawing: numeral 17 indicates a field insulating film which is made of $SiO_2$ (i.e., a silicon oxide film); numeral 19 indicates an interlayer insulating film which is made of PSG (or phosphosilicate glass); and numeral 20 indicates aluminum wiring.

As the source and drain regions 7 have an LDD structure in the N-channel MOSFET according to the CMOSIC having the structure thus far described, it is possible to weaken the field intensity by effect of the semiconductor regions 9 of low impurity concentration and to reduce the resistance by the semiconductor regions 8 of high impurity concentration. Thus, it is possible to raise the breakdown voltage of the drain junction, i.e., the PN junction between the drain region and the well, and to reduce the short channel effect.

In the P-channel MOSFET 2, the P-channel layer 15 and the $P^+$-type source and drain regions 13 which have the same conductivity type as that of the former and the offset structure, the continuously and integrally formed.

A part (existed below the side wall spacer 16), which is bounded on one end by channel and on the other end by the region 13, of the channel layer 15 has the same action as the regions 9 of the N-channel MOSFET and acts as a region for weakening the electric field in the vicinity of the junction formed by the drain regions 13. In other words, this structure can be considered as a kind of LDD structure. This makes it possible to improve the breakdown voltage of the drain junction and to suppress the generation of hot carriers.

Thanks to the presence of the channel layer 15, the source and drain regions 13 of high impurity concentration need not have their ends diffusing so far as to reach below the gate electrode 12. As a result, it is possible to reduce the short channel effect and Miller capacitance.

Since the source and drain regions 13 need not be formed to reach below the gate electrode 12, they can be formed to have a high impurity concentration and to reduce their resistance.

The P-channel MOSFET 2 has its channel formed into the so-called "buried channel", i.e., formed mainly in the junction between channel layer 15 and the well 11. In this case, more specifically, the MOSFET 2 is made to be the enhancement type not to be the depletion type, due to the difference $\phi_{MS}$ between the work functions of the gate electrode 12 and the channel 14. For this purpose, an N-type impurity, e.g., phosphorous is introduced into the gate electrode 12 with such a high concentration that the sheet resistance is over ten ohms per square to over twenty ohms per square, whereas the N-type channel layer 15 is made very shallow. The carrier mobility is raised by the buried channel. The hot carriers are not much affected by the electric field of the gate electrode 12 because the gate electrode 12 and the channel are spaced at a distance. This prevents hot carriers from being injected into the gate insulating film 18. Since the drain junction is not below the gate electrode 12, moreover, the electric field is weakened from this point, too.

The aforementioned effects can be easily attained because the MOSFET 2 is of the buried channel type and has source and drain regions which are constructed to be apart from the gate electrode.

This makes it possible to achieve the short channel, i.e., further scaling-down of not only the N-channel MOSFET 1 but also the P-channel MOSFET 2. Thus, it is possible to achieve high integration of a semiconductor integrated circuit device such as a P-channel MOSFET or a CMOS including the former.

The gate electrode 12 may be any that has a work function equal or similar to polycrystalline silicon doped with an N-type impurity in high concentration.

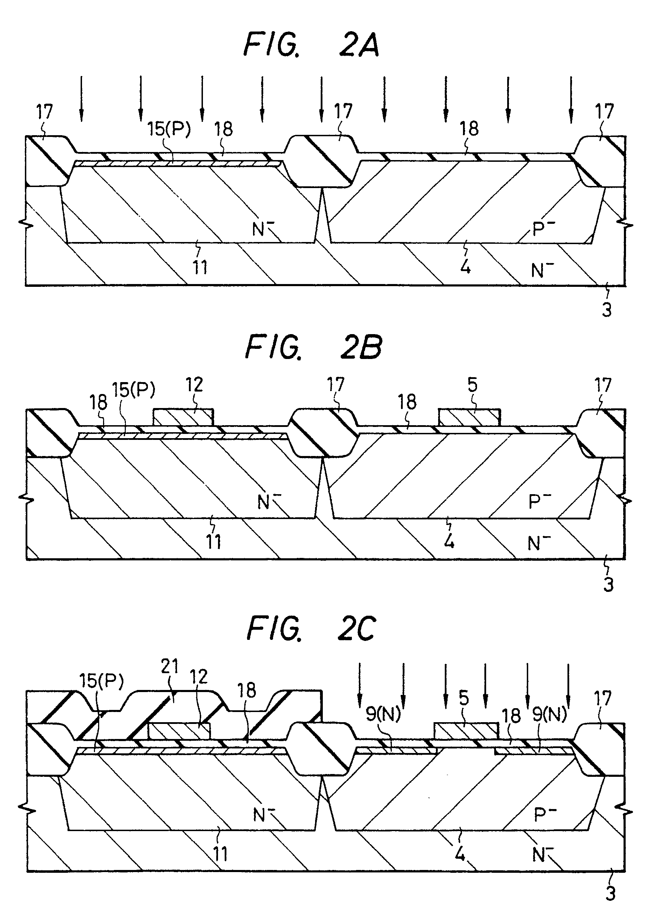

Next, one example of the process for fabricating the aforementioned CMOS device of Fig. 1 will be described in the following with reference to Figs. 2A to 2G.

First of all, as shown in Fig. 2A, an $P^-$-type well 4 having a concentration of $1 \times 10^{16}$ $cm^{-3}$ and an $N^-$-type well 11 having a concentration of $2 \times 10^{16}$ $cm^{-3}$ are formed in an $N^-$-type silicon substrate 3 having an impurity concentration of $4 \times 10^{14}$ $cm^{-3}$. Moreover, a field insulating film 17 of $SiO_2$ is formed by the local thermal oxidation of the main surface of the substrate 3. After this, the gate insulating film 18 is formed by thermal oxidation of the main surface of the substrate 3 or the portion (or active region) without the field insulating film 17.

In this state, the threshold voltage of the N-channel MOSFET 1 is adjusted by implanting boron all over the surface. As a result of this ion implantation, on the other hand, the P-type channel layer 15 having a concentration of $5 \times 10^{16}$ cm$^{-3}$ (or a dosage of $1 \times 10^{12}$ cm$^{-2}$) is formed in the surface of the N-type well 11. In the present embodiment, the control of the threshold voltage and the formation of the buried channel are carried out by the same ion implantation step. For this purpose, the impurity concentration of the well 11 is independently determined by forming the well 11. Thus, it is facilitated to set the dosage of the ion implantation.

Next, polycrystalline silicon formed on the whole surface of the substrate by the CVD is etched selectively. As a result, as shown in Fig. 2B, the gate electrodes 5 and 12 are formed on the gate insulating film 18.

One region (i.e., the N-type well 11) is masked with a photoresist film 21, as shown in Fig. 2C. In this state, an N-type impurity such as phosphorous is implanted by using the gate electrode 5 as a mask. As a result, semiconductor regions 9 having a low impurity concentration of $1 \times 10^{18}$ cm$^{-3}$ (i.e., a dosage of $1 \times 10^{13}$ cm$^{-2}$) are formed in the P-type well 4.

Next, after removal of the photoresist film 21, an SiO$_2$ film is deposited on the whole surface of the substrate by the chemical vapor deposition (CVD) method and is anisotropically etched by the reactive ion etching (RIE) method. As a result, the side wall spacers 6 and 16 are formed at both the sides of the gate electrodes 5 and 21, respectively, as shown in Fig. 2D.

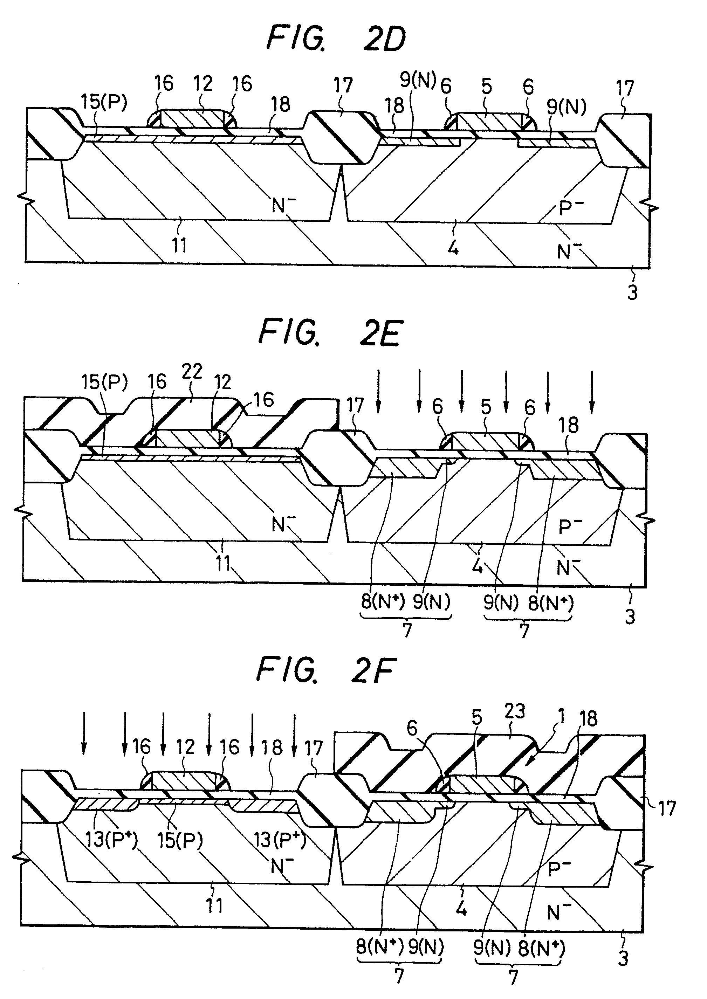

As shown in Fig. 2E, moreover, the N-type well 11 is masked with a photoresist film 22. In this state, an N-type impurity such as arsenic is implanted by using the gate electrode 5 and the side wall spacers 6 as the mask. Thus, the semiconductor regions 8 having a high impurity concentration of $1 \times 10^{21}$ cm$^{-3}$ (i.e., a dosage of $1 \times 10^{16}$ cm$^{-2}$) are formed. As a result, the aforementioned lightly doped regions 9 and the heavily doped layers 8 form together the source and drain regions 7 having the LDD structure. In other words, an N-channel MOSFET 1 having an LDD structure is completed on the P-type well 4.

Next, as shown in Fig. 2F, the N-channel MOSFET thus completed is masked with a photoresist film 23. In this state, a P-type impurity such as boron is implanted by using the gate electrode 12 and the side wall spacers 16 as the mask. The concentration is relatively as high as $10^{20}$ cm$^{-3}$ (i.e., a dosage of $2 \times 10^{15}$ cm$^{-2}$). The diffusion is made until the ends of the regions 13 reach midway below the side wall spacers 16.

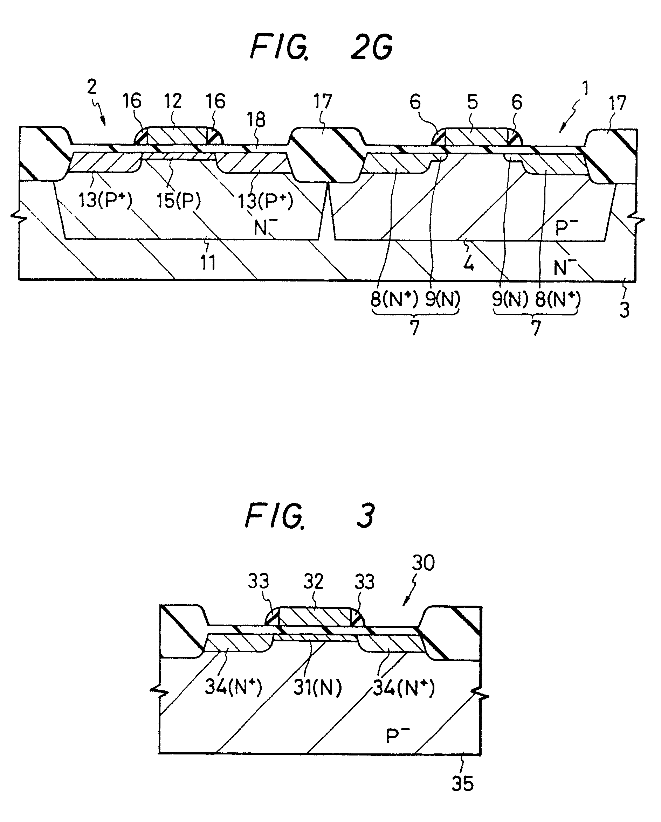

As a result, as shown in Fig. 2G, the source and drain regions 13 separated from the gate electrode 12 and be integral with the aforementioned channel layer 15 are formed to complete the P-channel MOSFET 2.

Then, the interlayer insulating film (i.e., the PSG film) 19 is formed. Next, aluminum wiring 20 is formed by patterning the aluminum film deposited by sputtering after forming contact holes. This completes the CMOSIC of Fig. 1. After this, a final passivation film is formed on the substrate.

The fabrication process thus far described facilitates the fabrication of the CMOSIC.

Specifically, the formation of the channel layer 15 can be effected at the step of introducing the impurity for adjusting the threshold voltage of the MOSFET of the opposite conductivity type. The side wall spacers can be formed at the step for making side wall spacers used for the LDD structure. Since the channel layer is formed in the well 11 having an impurity concentration different from and higher than that of the substrate 3, the step of introducing the impurity of the conductivity type opposite to that of the channel layer for forming the buried channel is unnecessary. The characteristics of the MOSFET 2 can be determined by controlling the concentration of the well 11.

The following effects can be attained with the present invention.

The source and drain regions of the MOSFET are constructed to be apart from the gate electrode and to be integral with the channel layer of the same conductivity type. Thus, the channel layer can partially act as a region for weakening the electric field and is enabled to have a low resistance by the source and drain regions of high impurity concentration. As a result, it is possible to complete a MOSFET which has a high breakdown voltage and a high-speed operation and which lessens the short channel effect.

Even if the structure is composed of the channel layer and the source and drain regions of common impurity, it can achieve the same breakdown voltage, high speed and reduce the short channel effect as those of an LDD structure. As a result, it is possible to further miniaturize the P-channel MOSFET and to achieve high integration of the semiconductor integrated circuit device including that MOSFET.

By making use of a portion of the step of fabricating the CMOSIC including the N-channel MOSFET of the LDD structure as it is, it is possible to form a CMOSIC including the transistor having the structure of the present invention and to execute the fabrication itself very easily.

For example, as shown in Fig. 3, the structure of the present invention can also be applied to an N-channel MOSFET 30 which is constructed on a P$^-$-type substrate (or well) 35. The N-channel MOSFET 30 comprises an N-type channel layer 31 of low concentration, a gate electrode 32 and N-type source and drain regions 34 of high concentration formed by self-alignment by using the gate electrode 32 and side wall spacers 33. Arsenic and/or phosphorous may be used as the impurity. In order to make an enhancement type N-channel MOSFET having the buried channel, it is essential that the gate electrode be made of either polycrystalline silicon which is heavily doped with a P-type impurity (e.g., boron) or a material which has a work function identical or similar to that of the former.

The ion implantation shown in Fig. 2A may be divided into two steps. More specifically, the ion implantation for forming the channel region 15 of one MOSFET can be conducted separately of ion implantation for adjusting the threshold voltage of the other MOSFET. In this modification, the dosage of the impurity to be implanted can be independently determined at the most proper value.

The well region 11 having the same conductivity type as that of the substrate 3 can be omitted. This omission is recommended especially when ion implantation shown in Fig. 2A is conducted at two steps, as described above.

The channel region 15 may be formed apart from the main surface of the semiconductor substrate. The depletion layer to be formed in the main surface of the semiconductor substrate by the work function of the gate electrode may be in the state including the channel region 15. In this case, the MOSFET is of the enhancement type.

In case the source and drain regions made of a semiconductor region of high impurity concentration are to be formed apart from the gate electrode, they may be formed without using side wall spacers but by another method such as ion implantation using a mask made of a photoresist film.

The gate electrode for forming the enhancement type MOSFET having the buried channel may have a polycide structure. In other words, it is possible to use the gate electrode which comprises a polycrystalline silicon layer doped with boron or phosphorous, and a layer of silicide of a refractory metal (e.g., Mo, W, Ta or Ti) overlying the former. The gate electrode may also have a structure in which the above-specified refractory metal layer is formed on the aforementioned polycrystalline line silicon layer.

When the side wall spacers are made of $SiO_2$ by the CVD, on the other hand, heat treatment can be conducted in the atmosphere of $O_2$ after the formation of the side wall spacers to improve the film quality of the side wall spacers thereby to reduce the trap of the hot carriers.

The description thus far made concerns to the case in which our invention is applied to the CMOSIC or the background field of application thereof. However, the present invention is not limited to the foregoing embodiment but can be applied to an IC which comprises only a P-channel MOSFET or an N-channel MOSFET.

When the present invention is to be applied to a CMOSIC, the N-channel MOSFET need not have an LDD structure. In a CMOSIC, the present invention may be applied to both N- and P-channel MOSFETs.

The present invention, moreover, can be applied to not only MOSFET but MISFET which has a gate insulating film without silicon oxide film such as silicon nitride film.

**Claims**

1. A process for fabricating a semiconductor integrated circuit device having MISFETs (1, 2) of first and second conductivity types comprising

forming a second semiconductor region (15) of the second conductivity type in a first semiconductor region (11) of the first conductivity type formed in a semiconductor substrate (3),

forming gate electrodes (5, 12), the gate electrode (12) of the MISFET (2) of the second conductivity type being formed over said second semiconductor region (15), and

forming source and drain regions (7, 13) by introducing impurities in said first semiconductor region (11), the source and drain regions (13) of said MISFET (2) of the second conductivity type being integral with said second semiconductor region (15) and apart from and at both sides of said gate electrode (12) of said MISFET (2) of the second conductivity type,

characterized in

that side wall spacers (6, 16) are formed on both side walls of said gate electrodes (5, 12) by depositing an insulating film and anisotropically etching the film by reactive ion etching, and

that the impurity for forming the source and drain regions (13) of the MISFET (2) of the second conductivity type is introduced in using said gate electrode (12) and side wall spacers (16) as a mask.

2. The process of claim 1, wherein said second semiconductor region (15) is formed by introducing an impurity for adjusting the threshold voltage of said MISFET (1) of the first conductivity type.

3. The process of claim 1 or 2, wherein said MISFET (1) of first conductivity type is formed in a semiconductor region (4) of the second conductivity type formed in said semiconductor substrate (3).

4. The process of any of claims 1 to 3, wherein said MISFETs (1, 2) of first and second conductivity types are N- and P-channel MOSFETs, respectively.

5. The process of claim 4, wherein the source and drain regions (7) of said N-channel MOSFET (1) have an LDD structure constructed by

forming a low impurity concentration region (9) by introducing an impurity using said gate electrode (5) as a mask, and

forming a high impurity concentration region (8) by introducing an impurity using said gate electrode (5) and said side wall spacers (6) as a mask.

**Revendications**

1. Procédé de fabrication d'un dispositif de circuit intégré à semiconducteurs possédant des MISFET (1, 2) de premier et second types de conductivité , comportant les étapes consistant à

former une seconde région semiconductrice (15) du second type de conductivité dans une première région semiconductrice (11) du premier type de conductivité formée dans un substrat semiconducteur (3),

former des électrodes de grille (5, 12), l'électrode de grille (12) du MISFET (2) du second type de conductivité étant formée au-dessus de ladite seconde région semiconductrice (15), et

former des régions de source et de drain (7, 13) en introduisant des impuretés dans ladite première région semiconductrice (11), les régions de source et de drain (13) dudit MISFET (2) du second type de conductivité faisant corps avec ladite seconde région semiconductrice (15), et espacées de et de part et d'autre de ladite électrode de grille (12) dudit MISFET (2) du second type de conductivité, caractérisé en ce que des entretoises de paroi latérale (6, 16) sont formées sur les deux parois latérales desdites électrodes de grille (5, 12) en déposant une pellicule isolante et en gravant de façon anisotropique la pellicule par gravure ionique réactive, et en ce que l'impureté pour former les régions de source et de drain (13) du MISFET (2) du second type de conductivité est introduite en utilisant ladite électrode de grille (12) et les entretoises de paroi latérale (16) comme masque.

2. Procédé selon la revendication 1, dans lequel ladite région semiconductrice (15) est formée en introduisant une impureté pour régler la tension de seuil dudit MISFET (1) du premier type de conductivité.

3. Procédé selon la revendication 1 ou 2, dans lequel ledit MISFET (1) du premier type de conductivité est formé dans une région semiconductrice (4) du second type de conductivité formée dans ledit substrat semiconducteur (3).

4. Procédé selon l'une quelconque des revendications 1 à 3, dans lequel lesdits MISFET (1, 2) des premier et second types de conductivité sont des MOSFET à canal N et P, respectivement.

5. Procédé selon la revendication 4, dans lequel les régions de source et de drain (7) dudit MOSFET à canal N (1) possèdent une structure LDD réalisée en

formant une région de concentration en impuretés faible (9) en introduisant une impureté en utilisant ladite électrode de grille (5) comme masque, et

en formant une région de concentration en impuretés élevée (8) en introduisant une impureté en utilisant ladite électrode de grille (5) et lesdites entretoises de paroi latérale (6) comme masque.

**Patentansprüche**

1. Verfahren zur Herstellung einer MISFETs (1, 2) eines ersten und eines zweiten Leitfähigkeitstyps enthaltenden integrierten Halbleiter-Schaltungsanordnung, wobei

in einem in einem Halbleitersubstrat (3) ausgebildeten ersten Halbleiterbereich (11) des ersten Leitfähigkeitstyps ein zweiter Halbleiterbereich (15) des zweiten Leitfähigkeitstyps gebildet wird,

Gate-Elektroden (5, 12) gebildet werden, wobei die Gate-Elektrode (12) des MISFETs (2) des zweiten Leitfähigkeitstyps über dem zweiten Halbleiterbereich (15) ausgebildet wird, und

durch Einbringen von Störstoffen in den ersten Halbleiterbereich (11) Source- und Drain-Bereiche (7, 13) gebildet werden, wobei die Source- und Drain-Bereiche (13) des MISFETs (2) des zweiten Leitfähigkeitstyps mit dem zweiten Halbleiterbereich (15) einstückig sowie auf beiden Seiten und getrennt von der Gate-Elektrode (12) des MISFETs (2) des zweiten Leitfähigkeitstyps sind,

dadurch gekennzeichnet,

daß an beiden Seitenwänden der Gate-Elektroden (5, 12) durch Auftragen eines Isolierfilms und anisotropes Ätzen des Films durch reaktives Ionenätzen Seitenwand-Abstandselemente (6, 16) ausgebildet werden, und

daß der Störstoff zur Ausbildung der Source- und Drain-Bereiche (13) des MISFETs (2) des zweiten Leitfähigkeitstyps unter Verwendung der Gate-Elektrode (12) und der Seitenwand-Abstandselemente (16) als Maske eingebracht wird.

2. Verfahren nach Anspruch 1, wobei der zweite Halbleiterbereich (15) durch Einbringen eines Störstoffs zur Einzustellung der Schwellenspannung des MISFETs (1) des ersten Leitfähigkeitstyps ausgebildet wird.

3. Verfahren nach Anspruch 1 oder 2, wobei der MISFET (1) des ersten Leitfähigkeitstyps in einem in dem Halbleitersubstrat (3) ausgebildeten Halbleiterbereich (4) des zweiten Leitfähigkeitstyps gebildet wird.

4. Verfahren nach einem der Ansprüche 1 bis 3, wobei die MISFETs (1, 2) des ersten und des zweiten Leitfähigkeitstyps N- bzw. P-Kanal-MOSFETs sind.

5. Verfahren nach Anspruch 4, wobei die Source- und Drain-Bereiche (7) des N-Kanal-MOSFETs (1) einen LDD-Aufbau haben, der dadurch hergestellt wird, daß

ein Bereich (9) niedriger Störstoffkonzentration durch Einbringen eines Störstoffs unter Verwendung der Gate-Elektrode (5) als Maske sowie

ein Bereich (8) hoher Störstoffkonzentration durch Einbringen eines Störstoffs unter Verwendung der Gate-Elektrode (5) und der Seitenwand-Abstandselemente (6) als Maske ausgebildet wird.

FIG. 1

## FIG. 2A

## FIG. 2B

## FIG. 2C

## FIG. 2D

## FIG. 2E

## FIG. 2F

## FIG. 2G

## FIG. 3